# EUROPEAN PATENT SPECIFICATION

(11) **EP 4 166 593 B1**
(45) Date of publication and mention of the grant of the patent: **27.08.2025**
(21) Application number: 21822067.1
(22) Date of filing: 10.06.2021
(51) Int. Cl.: C08G 59/40, H01L 23/373, C08K 5/3437, C08L 101/00, C08L 63/00, C08K 3/013

(54) **HEAT-CONDUCTIVE SHEET AND SEMICONDUCTOR MODULE INCLUDING SAID HEAT-CONDUCTIVE SHEET**
WÄRMELEITENDE FOLIE UND HALBLEITERMODUL MIT DER WÄRMELEITENDEN FOLIE
FEUILLE THERMOCONDUCTRICE ET MODULE À SEMI-CONDUCTEUR COMPRENANT LADITE FEUILLE THERMOCONDUCTRICE

(30) Priority: 10.06.2020 JP 2020101163
(43) Date of publication of application: 19.04.2023
(73) Proprietor: Nitto Shinko Corporation, Sakai-shi, Fukui 910-0381 (JP)
(72) Inventor: MORI, Munehiro, Sakai-shi, Fukui 910-0381 (JP)
(74) Representative: Stolmár & Partner Patentanwälte PartG mbB
(86) International application number: PCT/JP2021/022065
(87) International publication number: WO 2021/251454

(56) References cited:
- JP-A- 2011 231 196
- JP-A- 2013 032 496
- JP-A- 2018 168 354
- US-A1- 2020 024 426

## Description

### CROSS-REFERENCE TO RELATED APPLICATION

This application claims priority to Japanese Patent Application No. 2020-101163.

### FIELD

The present invention relates to a thermal conductive sheet and a semiconductor module including the thermal conductive sheet.

### BACKGROUND

Conventionally, a thermal conductive sheet having a resin layer formed by a resin composition that includes a thermosetting resin, a curing agent, and an inorganic filler has been known in the electronics field (For example, Patent Literature 1).

Patent Literature 1 below discloses that a thermal conductive sheet is formed by causing a metal foil to support the resin layer.

Such a thermal conductive sheet is used in a semiconductor module including a semiconductor device to cause heat generated by the semiconductor device to be transferred to a heat dissipation surface that dissipates the heat. More specifically, in a semiconductor module that includes a semiconductor device, a heat sink that supports semiconductor device and transfers heat generated by the semiconductor device, and a radiator arranged at a position overlapping the heat sink on an opposite side to a side on which the semiconductor device is supported, the thermal conductive sheet is interposed between the heat sink and the radiator in order to transfer the heat transferred from the heat sink to the heat dissipation surface of the radiator. The interposition of the thermal conductive sheet between the heat sink and the radiator is performed so that the resin layer is adhered to the heat sink and the metal foil comes into contact with the radiator. Such a thermal conductive sheet is adhered to the heat sink by causing the resin layer to contact the heat sink before the thermosetting resin of the resin layer is cured, and then causing the thermosetting resin to be cured.

### CITATION LIST

### Patent Literature

Patent Literature 1: JP 2013-32496 A

### SUMMARY

### Technical Problem

In the thermal conductive sheet as described above, the content of the inorganic filler in the resin layer is set to be relatively high in order to improve the thermal conductive properties. However, the higher the content of the inorganic filler in the resin layer, the lower the content of the thermosetting resin in the resin layer. In such a case, there is a problem that if a surface of an adherend such as a heat sink is not sufficiently flat, the adherend and the resin layer cannot be sufficiently adhered to each other. Also, there is another problem that the configuration with the thermal conductive sheet interposed between the heat sink and the radiator makes it difficult for the thermal conductive sheet to have a relatively high heat dissipation capability and a relatively high break down voltage (BDV), that is, it is difficult for the thermal conductive sheet to simultaneously achieve an improved heat dissipation capability and an improved break down voltage.

Therefore, it is an object of the present invention to provide a thermal conductive sheet that can ensure more sufficient adhesion to an adherend, while simultaneously achieving both an improved heat dissipation capability and an improved break down voltage, even if the surface of the adherend is not sufficiently flat and smooth, and to provide a semiconductor module including the thermal conductive sheet.

### Solution to Problem

A thermal conductive sheet according to the present invention includes a resin layer composed of a resin composition that includes a thermosetting resin, a curing agent, and an inorganic filler, the curing agent including a benzoxazine derivative represented by a formula (1) below. 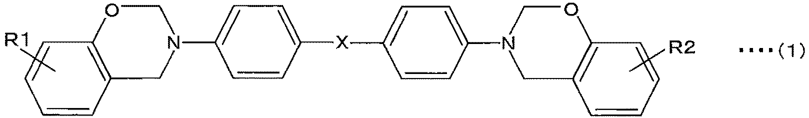 (where, in the formula (1) above, X is -CH₂-, -C(CH₃)₂-, or -SO₂-, and
R1 and R2 each are an alkyl group represented by -H, -CₙH₂ₙ₊₁ (where n is an integer of 1 or more and 10 or less) or an aryl group.)

A semiconductor module according to the present invention includes:
a semiconductor device,
a heat dissipation surface for dissipating heat generated by the semiconductor device, and
a thermal conductive sheet for transferring the heat to the heat dissipation surface, in which the thermal conductive sheet is the aforementioned thermal conductive sheet.

### BRIEF DESCRIPTION OF DRAWINGS

Fig. 1 is a cross-sectional view showing a structure of a thermal conductive sheet according to an embodiment of the present invention.
Fig. 2 is a cross sectional view schematically showing a semiconductor module according to an embodiment of the present invention.
Fig. 3 is a top view showing a laminated body subjected to etching.
Fig. 4 is a cross-sectional view showing an arrangement in measurement of a break down voltage.

### DESCRIPTION OF EMBODIMENTS

Hereinafter, an embodiment of the present invention will be described.

### (Thermal conductive sheet)

A thermal conductive sheet according to this embodiment includes a resin layer composed of a resin composition that includes a thermosetting resin, a curing agent, and an inorganic filler.

Among components included in the resin composition, the thermosetting resin and the curing agent are components that eventually form a cured product. That is, the thermosetting resin and the curing agent each are a polymerizable component to be turned into a cured resin by polymerization. More specifically, in the resin composition, the thermosetting resin is cured together with the curing agent to be thereby turned into the cured resin. Among the components included in the resin composition, the inorganic filler is a component that imparts good thermal conductive properties to the cured product by being included together with the cured resin in the cured product. In addition to the thermosetting resin, the curing agent, and the inorganic filler, the resin composition can include additives commonly used as a plastic containing chemical in a range so as not to impair the effect of the present invention.

In the thermal conductive sheet according to this embodiment, the content ratio of the polymerizable components (i.e., the thermosetting resin and the curing agent) with respect to 100 parts by mass of the cured product is preferably 5 parts by mass or more and 70 parts by mass or less, more preferably 10 parts by mass or more and 40 parts by mass or less.

The content of the inorganic filler in the thermal conductive sheet according to this embodiment is preferably 50 volume% or more and 90 volume% or less based on a total volume of solid content in the cured resin composition. Thereby, the thermal conductive sheet according to this embodiment can have more sufficient heat dissipation capability (thermal conductive properties). Note that the expression "sufficient heat dissipation capability (thermal conductive properties)" herein means that the thermal conductivity in the thermal conductive sheet is 10 W/m·K or more. The thermal conductivity can be measured by a method to be described later.

Further, the resin composition includes the additives preferably 0.005 parts by mass or more and 0.05 parts by mass or less, more preferably 0.01 parts by mass or more and 0.03 parts by mass or less, with respect to 100 parts by mass of the inorganic filler.

Examples of the thermosetting resin include epoxy resins, phenol resins, melamine resins, urea resins, unsaturated polyester resins, alkyd resins, polyurethane resins, polyimide resins, silicone resins, modified acrylic resins, and diallyl phthalate resins. Among them, the epoxy resins are preferably used. Among the epoxy resins, at least one of a bisphenol A type epoxy resin represented by a formula (2) below and a bisphenol F type epoxy resin represented by a formula (3) below is preferably used. A bisphenol A type epoxy resin with n=0 in the formula (2) below is preferable as the bisphenol A type epoxy resin, and a bisphenol F type epoxy resin with n=0 in the formula (3) below is preferable as the bisphenol F type epoxy resin. In the formulae (2) and (3) below, Ra, Rb, Rc, Rd, Re, Rf, Rg, and Rh each represent 0 to 4 monovalent group(s) in each benzene ring, and each are an alkyl group represented by -H or - CₙH₂ₙ₊₁ (where n is an integer of 1 or more and 10 or less). Examples of the commercially available bisphenol A type epoxy resin include the product name "JER 828" manufactured by Mitsubishi Chemical Holdings Corporation, and examples of the commercially available bisphenol F type epoxy resin include the product name "YSLV-80XY" manufactured by NIPPON STEEL Chemical & Material Co., Ltd. that is a tetramethylbisphenol F type epoxy resin. 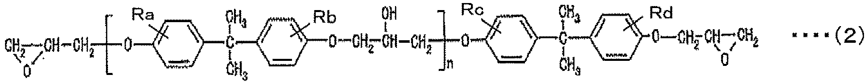 where n is an integer of 0 or more. 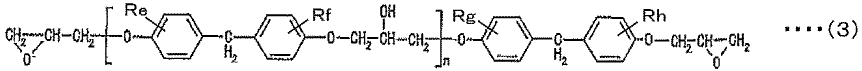 where n is an integer of 0 or more.

When the thermosetting resin is an epoxy resin, the ratio of the total amount of the epoxy resin and the curing agent in the polymerizable component is preferably 80 mass% or more and 100 mass% or less, more preferably 90 mass% or more and 100 mass% or less.

The curing agent includes a benzoxazine derivative represented by a formula (1) below. 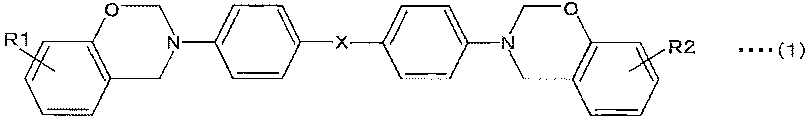 (where, in the formula (1) above, X is -CH₂-, -C(CH₃)₂-, or -SO₂-, and
R₁ and R₂ each are an alkyl group represented by -H, -CₙH₂ₙ₊₁ (where n is an integer of 1 or more and 10 or less) or an aryl group.)

The benzoxazine derivative represented by the formula (1) above denotes a Pd type benzoxazine derivative. When the thermosetting resin is crosselinked by the benzoxazine derivative with a rigid structure to have a cured structure, the cured structure becomes a structure having a small free volume so that the thermosetting resin can have excellent thermal characteristics and mechanical characteristics. Therefore, the Pd type benzoxazine derivative is preferable for use as the curing agent in the resin composition of the thermal conductive sheet.

Among benzoxazine derivatives represented by the formula (1) above, the curing agent is preferably a compound, where X is represented by -CH₂-, and R1 and R2 are each represented by -H, that is, a Pd type benzoxazine represented by a formula (1a) below.

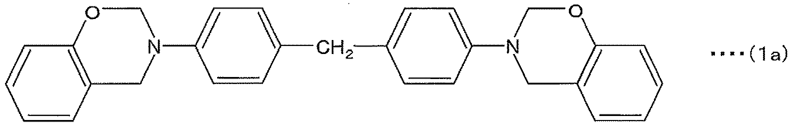

When the thermosetting resin is an epoxy resin, a molar ratio of an epoxy group of the epoxy resin to a benzoxazine ring of the curing agent is preferably 0.8 or more and 1.2 or less. Thereby, the thermal conductive sheet according to this embodiment can more sufficiently ensure the adhesion to the adherend.

Examples of the inorganic filler include a boron nitride filler, an aluminum nitride filler, a silicon nitride filler, a gallium nitride filler, an alumina filler, a silicon carbide filler, a silicon dioxide filler, a magnesium oxide filler, and a diamond filler. Among them, the boron nitride filler is preferable. The inorganic filler is preferably dispersed in the thermosetting resin. The inorganic filler preferably includes aggregated particles in which a plurality of primary particles are aggregated. The distance between the particles in the thermosetting resin can be shortened by inclusion of the aggregated particles, thereby improving the thermal conductive properties between the particles.

The thermal conductive sheet according to this embodiment can more sufficiently ensure the adhesion to an adherend and can simultaneously have both improved heat dissipation capability (thermal conductive properties) and improved break down voltage even in the case where an adherend does not have a sufficiently flat and smooth surface, because the thermal conductive sheet has a resin layer composed of a resin composition that includes a thermosetting resin, a curing agent, and an inorganic filler, the curing agent being a benzoxazine derivative represented by the formula (1) above. The present inventor presumes that these are achieved because of the reason below.

As explained in the section of EXAMPLES to be described later, the resin layer of the thermal conductive sheet according to this embodiment that is composed of the aforementioned resin composition is evaluated to have a good flexibility in a state before curing (i.e., in a B stage state). Therefore, it is assumed that, even when a surface of the adherend such as a heat sink is not sufficiently flat and smooth, the thermosetting resin in the resin layer can sufficiently enter recess of the adherend to thereby be able to more sufficiently ensure the adhesion between the resin layer and the adherend. Since the adhesion between the resin layer and the adherend is assumed to be more sufficiently ensured in the state before curing in this way, it is assumed that, when the thermosetting resin is cured (i.e., when it is brought into a C stage state), the resin layer can be adhered to the adherend, while the adhesion between the resin layer and the adherend is more sufficiently ensured. Further, as described above, since the resin layer of the thermal conductive sheet according to this embodiment has good flexibility in the state before curing, the thermosetting resin is excellent in followability to the surface of the inorganic filler to be included in the resin layer and is thus more sufficiently adhered to the surface of the inorganic filler. Therefore, it is considered that even when the thermosetting resin is cured into a cured resin, the state where the surfaces of the cured resin and the inorganic filler are kept adhered to each other can be relatively maintained. It is considered that, as a result, voids caused by peeling of the cured resin from the inorganic filler at an interface between the cured resin and the inorganic filler can be made relatively small, so that the break down voltage of the resin layer can be improved. Further, since the state where the surfaces of the cured resin and the inorganic filler are kept adhered to each other in the resin layer is assumed to be able to be relatively maintained, a relatively large amount of inorganic filler can be included in the resin layer while the reduction in break down voltage of the resin layer can be suppressed, so that the heat dissipation capability of the resin layer can be improved.

When the thermosetting resin includes an epoxy resin, adhesion force caused at the interface between the thermosetting resin and the inorganic filler can be further improved. Thereby, the heat dissipation capability in the thermal conductive sheet can be further improved. Also, when the thermosetting resin includes an epoxy resin, the thermal conductive sheet can have excellent adhesion to the adherend. Thereby, thermal resistance caused at the interface between the thermal conductive sheet and the adherend can be reduced. Thus, the heat dissipation capability in the thermal conductive sheet can be further improved.

In order to further enhance the heat dissipation capability of the resin layer, it is necessary to cause heat transfer by lattice vibration generated in crystal structure of the inorganic filler to be sufficiently performed in the resin layer. In order to cause the heat transfer by lattice vibration to be sufficiently performed, it is preferable that the resin layer be made to have more sufficient hardness by more sufficiently progressing the curing reaction of the thermosetting resin. Here, when at least one of the bisphenol A type epoxy resin represented by the formula (2) above and the bisphenol F type epoxy resin represented by the formula (3) above is used as the thermosetting resin, the thermosetting resin is assumed to have a high affinity with the benzoxazine derivative represented by the formula (1) above since these epoxy resins each have the same structural unit as that of the benzoxazine derivative represented by the formula (1) above. Therefore, it is assumed that, when at least one of the bisphenol A type epoxy resin and the bisphenol F type epoxy resin is used as the thermosetting resin, it is possible to progress the curing reaction of the thermosetting resin more sufficiently to cause the resin layer to have more sufficient hardness so that the heat transfer by lattice vibration can be more sufficiently performed. Thereby, the resin layer is assumed to have more sufficient heat dissipation capability by using at least one of the bisphenol A type epoxy resin represented by the formula (2) above and the bisphenol F type epoxy resin represented by the formula (3) above as the thermosetting resin.

Examples of the additives include a curing accelerator for accelerating the curing reaction of the thermosetting resin with the curing agent, and also include a dispersant, a tackifier, an aging retardant, an antioxidant, a processing aid, a stabilizer, a defoamer, a flame retarder, a thickener, and a pigment.

Examples of the curing accelerator include tetraphenylphosphonium tetraphenylborate, imidazoles, triphenylphosphate (TPP), an amine-based curing accelerator, and a protonic acid. Examples of the amine-based curing accelerator include boron trifluoride monoethylamine, and examples of the protonic acid include*p-*toluenesulfonic acid.

In the thermal conductive sheet according to this embodiment, the resin composition includes preferably 0.5 parts by mass or more and 5.0 parts by mass or less of the curing accelerator, more preferably 0.5 parts by mass or more and 3.0 parts by mass or less of the curing accelerator, based on the total amount of 100 parts by mass of the thermosetting resin and the curing agent.

In the thermal conductive sheet according to this embodiment, the resin composition can be in a state where it is not completely cured, while the curing reaction is somewhat progressed. In other words, the resin composition can be in a state where the curing reaction is progressed partially in the resin composition, that is, in a state where the B stage state and the C stage state coexist with each other. For example, the resin composition can be such that the resin composition is applied in a sheet shape while having a fluidity, and then comes into a state where it is partly cured. The resin composition includes the thermosetting resin, the curing agent, and the inorganic filler even in a state where the curing reaction has partly progressed. On the other hand, the resin composition is preferably entirely in a state before curing (i.e., the B stage state) in terms of the adhesion to the adherend and the adhesion to the surface of the inorganic filler.

Metal is preferable as a material of the adherend for the thermal conductive sheet. Specifically, metal including copper or aluminum is preferable.

The thermal conductive sheet according to this embodiment can be used for a metal base circuit board. The metal base circuit board is formed by, for example, a thermal conductive sheet with a circuit layer adhered thereto. Since the metal base circuit board having such a configuration includes the thermal conductive sheet according to this embodiment, the metal base circuit board also has improved heat dissipation capability.

Further, the thermal conductive sheet according to this embodiment is used for, for example, a power module. The power module is formed by, for example, mounting a heating element such as a semiconductor chip or a power IC on a circuit layer of the metal base circuit board, temporarily sealing these elements with silicone gel, and resin molding on the silicone gel. Since the power module having such a configuration includes the thermal conductive sheet according to this embodiment, the power module also has improved heat dissipation capability.

### (Semiconductor module)

The semiconductor module according to this embodiment includes: a semiconductor device; a heat dissipation surface that dissipates heat generated by the semiconductor device; and a thermal conductive sheet for transferring the heat to the heat dissipation surface. In the semiconductor module according to this embodiment, the thermal conductive sheet according to the aforementioned embodiment is used as the thermal conductive sheet. The thermal conductive sheet forms at least a part of a path for transferring the heat generated by the semiconductor device. In the thermal conductive sheet, heat is transferred in a thickness direction.

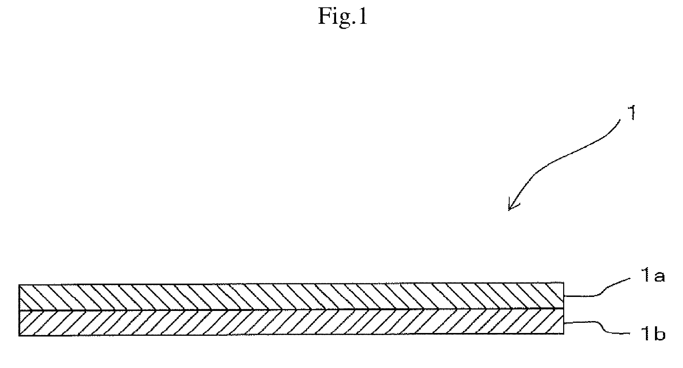

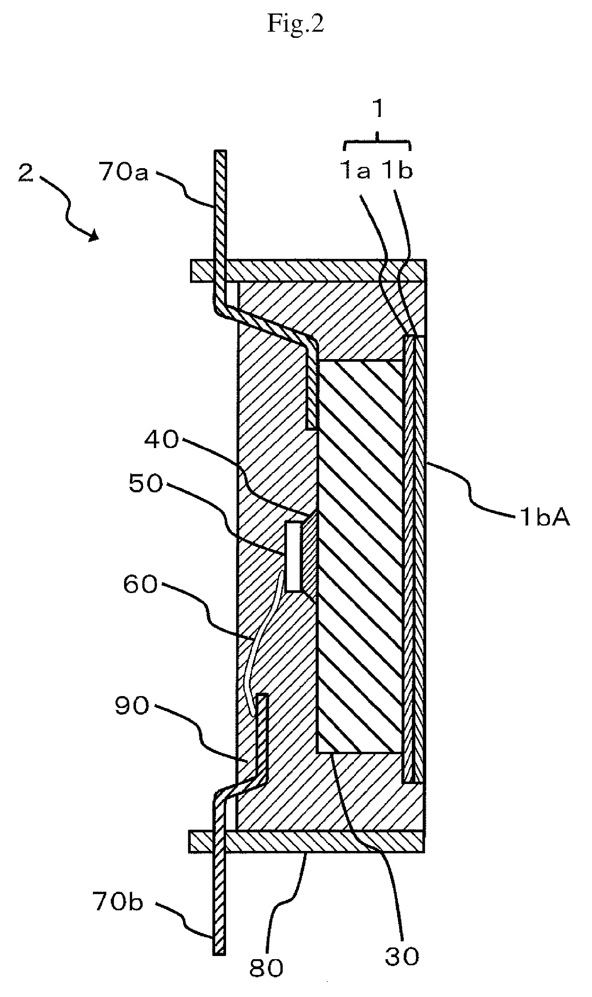

Hereinafter, the semiconductor module according to this embodiment will be described with reference to Fig. 1 and Fig. 2.

As shown in Fig. 2, in the semiconductor module 2 according to this embodiment, a rectangular-shaped plastic case 80 that has a flat box shape with upper and lower openings forms a peripheral wall. In the semiconductor module 2, a semiconductor device 50 and a heat sink 30 are housed inside the plastic case 80.

The heat sink 30 is formed by a metal block sufficiently larger than the semiconductor device 50 to rapidly remove the heat of the semiconductor device 50, and is connected to the semiconductor device 50 via solder 40. More specifically, the heat sink 30 has a thickness of about half the height of the peripheral wall formed by the plastic case 80 and a rectangular plate shape somewhat smaller than an opening area of the plastic case 80, and is housed inside the plastic case 80 while mounting the semiconductor device 50 on a central part of an upper surface thereof.

Further, one end of a first terminal 70a passing through the plastic case 80 in a horizontal direction is soldered on the upper surface of the heat sink 30.

In the heat sink 30, a second terminal 70b passes through the plastic case 80 in the horizontal direction at an opposite position to the passing position of the first terminal 70a and is electrically connected to the semiconductor device 50, to thereby form an electrical path between these terminals. That is, the electrical current flows thorough the inside of the heat sink 30 when it is supplied with electricity. Therefore, in addition to generation of heat of the semiconductor device 50, the temperature rise due to Joule heat caused by the electric current flowing through the heat sink 30 occurs in the semiconductor module 2 according to this embodiment. In the semiconductor module 2, a mold resin 90 is filled inside the plastic case 80, and the semiconductor device 50 and the like except a bottom surface side of the heat sink 30 are embedded in the mold resin 90.

In the semiconductor module 2 according to this embodiment, the thermal conductive sheet 1 as shown in Fig. 1 is used as the thermal conductive sheet. As shown in Fig. 1, the thermal conductive sheet 1 is formed as a thermal conductive sheet having a metal foil in which a resin layer 1a is supported by a metal foil layer 1b. In general, when the resin layer 1a has a small thickness, it can decrease the thermal resistance from the later-described heat sink 30 to the metal foil layer 1b, which is advantageous in heat dissipation and thus is preferable. On the other hand, when the resin layer 1a has an excessively small thickness, there is a risk of reducing the reliability in the electrical insulation properties. Therefore, the resin layer 1a is generally formed to have a thickness of 100 µm or more and 300 µm or less by a resin composition having a volume resistivity of 1×10¹⁴ Ω·cm or more after the resin composition is heat cured.

The semiconductor module 2 according to this embodiment includes the thermal conductive sheet 1 that has an area larger than the lower surface of the heat sink 30 and smaller than the opening of the plastic case 80, and that is disposed in the semiconductor module 2 to cover the entire area of the lower surface of the heat sink 30 with the resin layer 1a adhered to the lower surface of the heat sink 30. In the semiconductor module 2 according to this embodiment, the metal foil layer 1b of the thermal conductive sheet 1 has a surface exposed on the lower side of the semiconductor module 2 so that a surface 1bA of the metal foil layer 1b can be used as a heat dissipation surface of the semiconductor module 2. That is, the surface 1bA of the metal foil layer 1b is exposed at the central part of the lower side of the semiconductor module 2 according to this embodiment, and the mold resin 90 is exposed between the surface 1bA of the metal foil layer 1b and the lower end surface of the plastic case 80 that forms an outer periphery of the semiconductor module 2.

In the semiconductor module 2 according to this embodiment, the exposed surface of the mold resin 90, the surface 1bA of the metal foil layer 1b, and the lower end surface of the plastic case 80 are formed to be substantially flush with each other to form the lower side of the semiconductor module 2, on which the radiator or the like is mounted, thereby allowing the surface of the radiator to be brought into surface contact with the surface 1bA. With this configuration, heat generated by the semiconductor device 50 can be dissipated via the thermal conductive sheet 1.

The matters disclosed herein include the following.
(1) A thermal conductive sheet including a resin layer composed of a resin composition that includes a thermosetting resin, a curing agent, and an inorganic filler, the curing agent including a benzoxazine derivative represented by a formula (1) below: 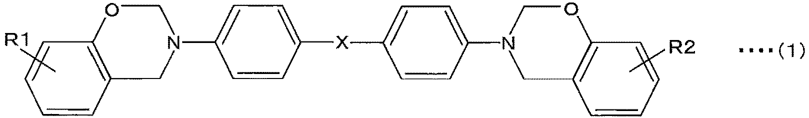 (where, in the formula (1) above, X is -CH₂-, -C(CH₃)₂-, or -SO₂-, and
   R1 and R2 each are an alkyl group represented by -H,-CₙH₂ₙ₊₁ (where n is an integer of 1 or more and 10 or less) or an aryl group.)
   According to this configuration, even if a surface of an adherend is not sufficiently flat and smooth, the thermal conductive sheet can more sufficiently ensure the adhesion to the adherend and can simultaneously achieve both the improved heat dissipation capability and the improved break down voltage.
(2) The thermal conductive sheet described in (1) above, in which the thermosetting resin includes an epoxy resin.
   According to this configuration, adhesion force caused at the interface between the thermosetting resin and the inorganic filler can be further improved. Thereby, the heat dissipation capability in the thermal conductive sheet can be further improved. Further, when the thermosetting resin includes the epoxy resin, the thermal conductive sheet can have excellent adhesion to the adherend. Thereby, thermal resistance caused at the interface between the thermal conductive sheet and the adherend can be reduced. Thus, the heat dissipation capability in the thermal conductive sheet can be further improved. Moreover, since the inclusion of the epoxy resin in the thermosetting resin enables the resin layer to have more sufficient hardness, the heat dissipation capability can be further improved in the thermosetting sheet.
(3) The thermal conductive sheet described in (2) above, in which
   a molar ratio of an epoxy group of the epoxy resin to a benzoxazine ring of the curing agent is 0.8 or more and 1.2 or less.
   According to this configuration, the thermal conductive sheet can more sufficiently ensure the adhesion to the adherend.
(4) The thermal conductive sheet described in any one of (1) to (3) above, in which
   a content of the inorganic filler is 50 volume% or more and 90 volume% or less based on a total volume of solid content in the cured resin composition.
   According to this configuration, the heat dissipation capability can be further improved.
(5) A semiconductor module including:
   a semiconductor device;
   a heat dissipation surface for dissipating heat generated by the semiconductor device; and
   a thermal conductive sheet for transferring the heat to the heat dissipation surface, where
   the thermal conductive sheet is the thermal conductive sheet described in any one of (1) to (4) above.

According to this configuration, even if a surface of an adherend is not sufficiently flat and smooth, the semiconductor module can more sufficiently ensure the adhesion to the adherend and simultaneously achieve both the improved heat dissipation capability and the improved break down voltage.

The thermal conductive sheet and the semiconductor module according to the present invention are not limited to the configuration of the aforementioned embodiments. Further, the thermal conductive sheet and the semiconductor module according to the present invention are not limited to those having the aforementioned operational effects. Various modifications can be made to the thermal conductive sheet and the semiconductor module according to the present invention.

### EXAMPLES

Next, the present invention will be described in more detail by way of Examples and Comparative Examples.

### (Example 1)

The thermosetting resin and the curing agent each described below were dissolved in methyl ethyl ketone at an equivalent ratio of 1:1 to prepare a varnish, followed by mixing the inorganic filler described below into the varnish and kneading them together to obtain a resin composition according to Example 1. The inorganic filler described below was included in the varnish to have the content of the inorganic filler described below being 63 volume% based on the total volume of solid content in the cured resin composition.
· Thermosetting resin: Epoxy resin A (bisphenol F type epoxy resin, YSLV-80XY, manufactured by NIPPON STEEL Chemical & Material Co., Ltd.)
· Curing agent: Benzoxazine derivative of a formula (1a) below (Pd type benzoxazine manufactured by SHIKOKU CHEMICALS CORPORATION)
· Inorganic filler: Boron nitride filler (BN filler (h-BN filler))

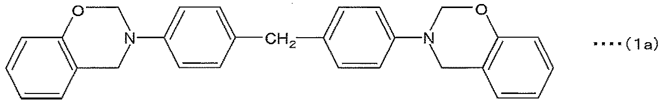

### <Thermal conductivity>

For the evaluation of thermal conductivity, a laminate sheet with metal foil was prepared in the following manner. First, the resin composition according to Example 1 was coated on a copper foil (area: 2,500 cm²) as a base material to have a thickness of about 200 µm. A coater method, namely, a roll-to-roll coating method, was adopted as a coating method, and dry conditions at 120 °C for 5 minutes were adopted. In this way, a first laminate sheet having a resin layer prepared by the resin composition according to Example 1 was prepared. Next, two first laminate sheets according to Example 1 were placed on each other to have their surfaces on the opposite side to the base materials facing each other, and hot pressed at a temperature of 100 °C and a pressure of 8 MPa for a period of 20 minutes to prepare a laminate sheet with metal foil having a resin layer thickness of 0.22 ± 0.04 mm.

A copper foil that is a metal foil was removed from each of both surfaces of the laminate sheet with metal foil by etching, then the resin laminate sheets each having a thickness of 1.00 mm ± 0.15 mm were taken out from the laminate sheet, then placed on each other, followed by hot pressing for the evaluation of thermal conductivity. Thereafter, the resin laminate sheets were cured by being exposed at a temperature of 200 °C and a pressure of 5 MPa for 4 hours. A resin cured product having a rectangular shape with each side of 10 mm ± 0.5 mm was cut out from the cured resin laminate sheet. Then, an antireflection agent (manufactured by Fine Chemical Japan Co., Ltd., Product No.: FC-153) was coated on both surfaces of the resin cured product thus cut out to prepare a thermal diffusivity measurement sample. The value of the thermal conductivity was calculated by multiplying the value of the thermal diffusivity measured for the thermal diffusivity measurement sample using a xenon flash analyzer (manufactured by NETZSCH, LFA-447 type) by the value of the specific heat measured by a heat flux DSC in accordance with JIS 7123:1987 and the value of the density measured by a water substitution method in accordance with JIS K 7122:1999. The value of the thermal diffusivity was obtained by arithmetically averaging the values of the thermal diffusivity measured for three measurement samples. The thermal diffusivity was measured at five points of each measurement sample, and the value obtained by arithmetically averaging the values at three points excluding the maximum value and the minimum value was taken as the measurement value of each of the measurement samples.

### <Break down voltage>

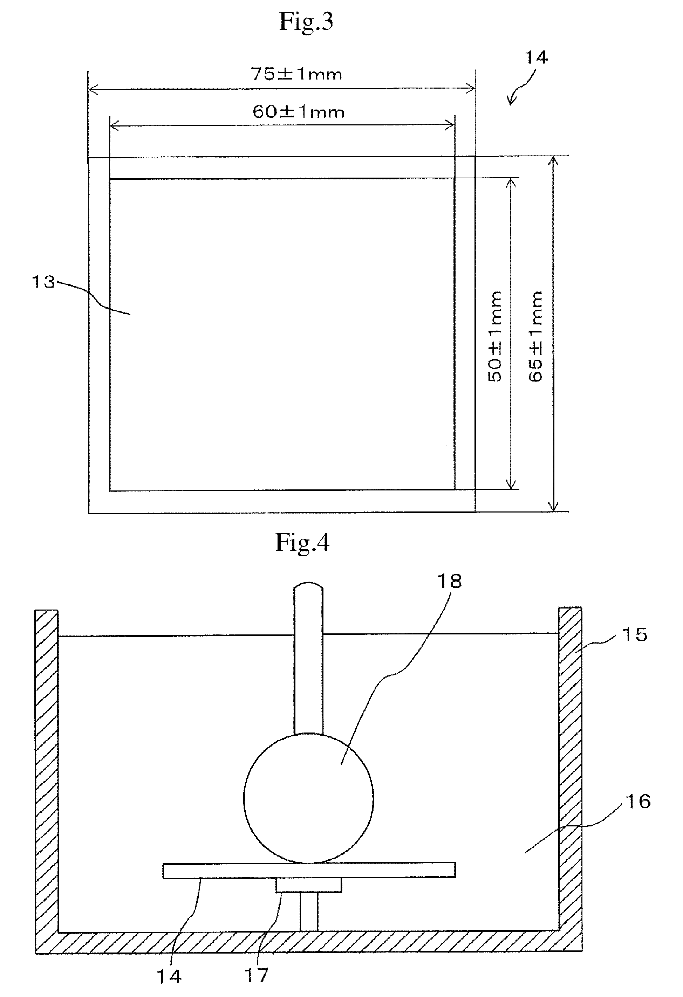

Break down voltage was measured by an electrical breakdown tester that can apply a voltage at a frequency of 50 or 60 Hz with a crest factor between 1.34 to 1.48 and outputs a maximum voltage of AC10kV (effective value). Details of the measurement method will be described with reference to Fig. 3 and Fig. 4. A second laminate sheet was obtained by peeling a copper foil on one side of the laminate sheet with metal foil of 75 ± 1 mm × 65 ± 1 mm. Then, an aluminum plate 13 was layered on the peeled surface in the second laminate sheet and then heated to obtain a third laminate sheet in which the second laminate sheet is integrated with the aluminum plate. Next, the third laminate sheet was further heated to cause the resin layer to be completely cured, to obtain a break down voltage measurement sample 14 shown in Fig. 1. The resin layer was prepared using the resin composition according to Example 1. Next, as shown in Fig. 4, the break down voltage measurement sample 14 was disposed on a brass disc electrode 17 (Φ: 40 mm) with the aluminum plate side facing downward in insulating oil 16 (JIS C2320:1999) in an oil tank 15. A brass spherical electrode 18 (Φ: 15 mm, weight: 50 g) was disposed on the break down voltage measurement sample 14 so as to be in contact with a substantially center part of the break down voltage measurement sample 14. While keeping the insulating oil 16 at 20 °C with a fluctuation of plus or minus 10 degrees, a voltage of AC3.0kV (effective value) was applied to the break down voltage measurement sample 14 for one minute. In the case where no electrical breakdown was caused, the voltage was rapidly increased by AC0.5kV (effective value) and applied for one minute, followed by increasing the voltage in a stepwise manner with a step of 0.5kV (effective value) (0.5kV (effective value) per step applied for one minute) until electrical breakdown occurred. Herein, the cutoff current was set at 10 mA as a criterion for determining the occurrence of the electrical breakdown. Further, the applied voltage lower by 0.5 kV (effective value) than the voltage that caused the electrical breakdown was divided by the thickness (unit: mm) of the break down voltage measurement sample 14 to determine the break down voltage.

### <Peel strength>

The resin composition according to Example 1 was coated on one surface of an electrolytic copper foil (thickness: 35 µm) to prepare two sheets each having a resin layer (thickness: 145 µm). Next, the resin layers of the two sheets were adhered to each other by hot pressing (3.0 MPa, 120 °C, 20 min), and a copper foil was peeled off from a back surface of the sheet. Then, an aluminum plate was placed on the surface from which the copper foil was peeled off to transfer the sheet on the aluminum plate by hot pressing (2.0 MPa, 120 °C, 20 min) and a copper foil was peeled off from another surface of the sheet to obtain a semi-cured sheet. Next, an adherend (1oz copper foil) was layered on the semi-cured sheet and subjected to hot pressing (2.0 MPa, 180 °C, 120 min) to cause the resin layer to be sufficiently cured, while causing the resin layer and the adherend to be integrated with each other. Thereafter, the cured product was cut into a size of 20 mm × 100 mm, and the adherend of the cut piece was processed (etched) to have a width of 10 mm to prepare a test piece for peeling test. A 90° peel test was performed for the test piece at a peeling strength of 50 mm/min and the adhesion strength between the adherend and the resin layer was evaluated by the peel strength.

### <Flexibility>

Flexibility was evaluated by a method according to JIS A 6909:2014. A test specimen for evaluation of the flexibility was prepared in the following manner. First, the resin composition according to Example 1 was coated on a copper foil (area: 2,500 cm²) as a base material to have a thickness of about 200 µm. A coater method, namely, a roll-to-roll coating method, was adopted as a coating method, and dry conditions at 120 °C for 5 minutes were adopted. In this way, a thermal conductive sheet with metal foil (i.e., a thermal conductive provided with a metal foil as a base material on one surface of the resin layer) was prepared for the resin composition according to Example 1. Next, a laminate thermal conductive sheet with metal foil (i.e., a thermal conductive sheet provided with a metal foil on each surface of the resin layer) having a resin layer thickness of 0.22 ± 0.04 mm was prepared by placing two thermal conductive sheets with metal foil on each other to have the surfaces, on each of which no base material is disposed, facing each other, and hot pressing at a temperature of 100 °C and a pressure of 8 MPa for 2 hours. Next, a copper foil that is a metal foil was removed from each of both surfaces of the thermal conductive sheet with metal foil by etching to take out a resin laminate sheet, from which a resin laminate sheet with each side of 10 mm ± 0.5 mm was cut out, to provide a resin laminate sheet as a test specimen for evaluation of the flexibility. The flexibility was evaluated by abutting a metal rod having a diameter of 10 mm on a substantially central part of the surface on one side of the test specimen for evaluation of the flexibility, bending the test specimen for evaluation of the flexibility at 90 ° along the curved surface of the metal rod, and performing visual observation on the presence or absence of cracking in the surface on the other side of the test specimen for evaluation of the flexibility. The flexibility was evaluated by evaluating three test specimens for evaluation of the flexibility. The case where cracking was found in none of the three specimens was evaluated as excellent, and the case where cracking was found even in one specimen was evaluated as failed. The flexibility was evaluated for the specimen for evaluation of the flexibility in the state before being cured (i.e., the B stage state).

The results of measurement of the thermal conductivity, the break down voltage, and the peel strength, and the results of evaluation of the flexibility are shown in Table 1.

### (Example 2)

A resin composition according to Example 2 was obtained in the same manner as Example 1 except that, an epoxy resin B (bisphenol A type epoxy resin, JER 828 manufactured by Mitsubishi Chemical Holdings Corporation) was used, instead of the epoxy resin A, as the thermosetting resin, and the inorganic filler was included in the varnish to be 64 volume% based on the total volume of solid content in the cured resin composition. Also, the thermal conductivity, the break down voltage, and the peel strength were measured, and the flexibility was evaluated for the resin composition according to Example 2 by the same method as explained in Example 1. The results are shown in Table 1 below.

### (Example 3)

A resin composition according to Example 3 was obtained in the same manner as Example 1 except that the inorganic filler was included in the varnish to be 73 volume% based on the total volume of solid content in the cured resin composition. Also, the thermal conductivity, the break down voltage, and the peel strength were measured, and the flexibility was evaluated for the resin composition according to Example 3 by the same method as explained in Example 1. The results are shown in Table 1 below.

### (Comparative Example 1)

A resin composition according to Comparative Example 1 was obtained in the same manner as Example 1 except that an epoxy resin C (EPPN 501HY manufactured by Nippon Kayaku Co., Ltd.) was used, instead of the epoxy resin A, as the thermosetting resin, DL-92 (manufactured by MEIWA PLASTIC INDUSTRIES, LTD.) was used, instead of the benzoxazine derivative represented by the formula (1a) above, as the curing agent, tetraphenylphosphonium tetraphenylborate (TPP-K (registered trademark) manufactured by Hokko Chemical Industry) was used as the curing accelerator, and the inorganic filler was included in the varnish to be 67 volume% based on the total volume of solid content in the cured resin composition. In the resin composition, 0.01 parts by mass of the curing accelerator was included based on 100 parts by mass in total of the thermosetting resin and the curing agent. Also, the thermal conductivity, the break down voltage, and the peel strength were measured, and the flexibility was evaluated for the resin composition according to Comparative Example 1 by the same method as explained in Example 1. The results are shown in Table 1 below. Table 1 also provides the glass transition temperature Tg which means the middle-point glass transition temperature according to JIS K7121:2012.

**Table 1**

| | Ex. 1 | Ex. 2 | Ex. 3 | C. Ex. 1 |
|---|---|---|---|---|
| Thermosetting resin | Epoxy resin A | Epoxy resin B | Epoxy resin A | Epoxy resin C |
| Curing agent | Benzoxazine derivative represented by formula (1a) | Benzoxazine derivative represented by formula (1a) | Benzoxazine derivative represented by formula (1a) | DL-92 |
| Curing accelerator | - | - | | TPPK |
| Inorganic filler | Boron nitride filler | Boron nitride filler | Boron nitride filler | Boron nitride filler |
| Inorganic filler content[volume%] | 63 | 64 | 73 | 67 |
| Thermal conductivity[W/(m-K)] | 14.0 | 14.2 | 16.3 | 14.5 |
| Break down voltage [kV/mm] | 62.5 | 62.5 | 45.0 | 38.3 |
| Peel strength [N/cm] | 2.0 | 2.0 | 2.0 | 2.0 |
| Glass transition temperature Tg[°C] | 209 | 210 | 209 | 220 |
| Flexibility | O | O | O | × |

As shown in Table 1, it is evident that, when the resin composition according to each of Examples 1 to 3 is used, the break down voltage is as high as 40 kV/mm or more, while the thermal conductivity being as high as 14 W/(m·K). Also, the flexibility is evaluated as "high" when the resin composition of any of Examples 1 to 3 is used according to the result of evaluation of the flexibility, and it is found that the flexibility is good. In contrast, it is evident that, when the resin composition of Comparative Example 1 is used, the break down voltage is as low as less than 40 kV/mm, while the thermal conductivity being as high as 14 W/(m·K) or more. Also, as the flexibility is evaluated as "failed" when the resin composition of Comparative Example 1 is used, it is evident that the flexibility decreases. From the aforementioned results, the use of the benzoxazine derivative represented by the formula (1) above as the curing agent in the thermal conductive sheet including a resin layer composed of the resin composition including the thermosetting resin, the curing agent, and the inorganic filler makes it possible to obtain a thermal conductive sheet that can simultaneously achieve both the thermal conductive properties and the electric breakdown resistance, and can ensure more sufficient adhesion to the adherend even if the surfaced of the adherend is not sufficiently flat and smooth,.

### REFERENCE SIGNS LIST

1: Thermal conductive sheet
2: Semiconductor module
30: Heat sink
40: Solder
50: Semiconductor device
60: Bonding wire
80: Plastic case
90: Mold resin
1a: Resin layer
1b: Metal foil layer
70a: First terminal
70b: Second terminal
1bA: Surface

## Claims

1. A thermal conductive sheet comprising a resin layer composed of a resin composition that comprises a thermosetting resin, a curing agent, and an inorganic filler, the curing agent comprising a benzoxazine derivative represented by a formula (1) below: 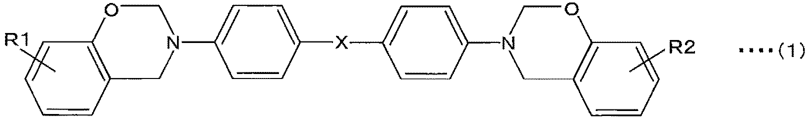 (where, in the formula (1) above, X is -CH₂-, -C(CH₃)₂-, or -SO₂-, and
R1 and R2 each are an alkyl group represented by -H,-CₙH₂ₙ₊₁ (where n is an integer of 1 or more and 10 or less) or an aryl group).

2. The thermal conductive sheet according to claim 1, wherein
the thermosetting resin comprises an epoxy resin.

3. The thermal conductive sheet according to claim 2, wherein
a molar ratio of an epoxy group of the epoxy resin to a benzoxazine ring of the curing agent is 0.8 or more and 1.2 or less.

4. The thermal conductive sheet according to any one of claims 1 to 3, wherein
a content of the inorganic filler is 50 volume% or more and 90 volume% or less based on a total volume of solid content in the cured resin composition.

5. A semiconductor module comprising:
a semiconductor device;
a heat dissipation surface for dissipating heat generated by the semiconductor device; and
a thermal conductive sheet for transferring the heat to the heat dissipation surface, wherein
the thermal conductive sheet is the thermal conductive sheet according to any one of claims 1 to 4.

## Patentansprüche

1. Wärmeleitfähige Folie, umfassend eine Harzschicht, die aus einer Harzzusammensetzung zusammengesetzt ist, die ein wärmehärtbares Harz, ein Härtungsmittel und einen anorganischen Füllstoff umfasst, wobei das Härtungsmittel ein Benzoxazinderivat umfasst, das durch die nachstehende Formel (1) dargestellt ist: 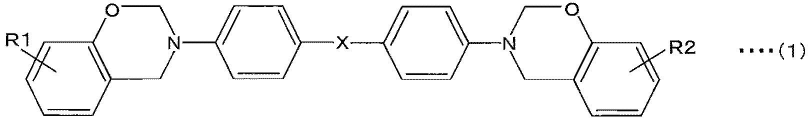 (wobei in obiger Formel (1) X -CH₂-, -C(CH₃)₂-, oder -SO₂- darstellt, und
R1 und R2 jeweils eine Alkylgruppe sind, die durch -H, -CₙH₂ₙ₊₁ (wobei n eine ganze Zahl von 1 oder mehr und 10 oder weniger ist) oder eine Arylgruppe dargestellt ist).

2. Wärmeleitfähige Folie nach Anspruch 1, wobei
das wärmehärtbare Harz ein Epoxidharz umfasst.

3. Wärmeleitfähige Folie nach Anspruch 2, wobei
ein Molverhältnis einer Epoxidgruppe des Epoxidharzes zu einem Benzoxazinring des Härtungsmittels 0,8 oder mehr und 1,2 oder weniger beträgt.

4. Wärmeleitfähige Folie nach einem der Ansprüche 1 bis 3, wobei
ein Gehalt des anorganischen Füllstoffs 50 Volumen-% oder mehr und 90 Volumen-% oder weniger beträgt, bezogen auf ein Gesamtvolumen des Feststoffgehalts in der gehärteten Harzzusammensetzung.

5. Halbleitermodul, umfassend:
eine Halbleitervorrichtung;
eine Wärmeableitungsoberfläche zum Ableiten von durch die Halbleitervorrichtung erzeugter Wärme; und
eine wärmeleitfähige Folie zum Übertragen der Wärme auf die Wärmeableitungsoberfläche, wobei
die wärmeleitfähige Folie die wärmeleitfähige Folie nach einem der Ansprüche 1 bis 4 ist.

## Revendications

1. Feuille thermoconductrice comprenant une couche de résine composée d'une composition de résine qui comprend une résine thermodurcissable, d'un agent de durcissement et d'une charge inorganique, l'agent de durcissement comprenant un dérivé de benzoxazine représenté par une formule (1) ci-dessous : 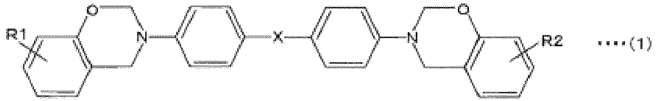 (où, dans la formule (1) ci-dessus, X est -CH₂-, -C(CH₃)₂-, ou -SO₂-, et
R1 et R2 sont chacun un groupe alkyle représenté par -H, ₋CₙH₂ₙ₊₁ (où n est un nombre entier de 1 ou plus et de 10 ou moins) ou un groupe aryle).

2. Feuille thermoconductrice selon la revendication 1, dans laquelle la résine thermodurcissable comprend une résine époxy.

3. Feuille thermoconductrice selon la revendication 2, dans laquelle
le rapport molaire entre un groupe époxy de la résine époxy et un anneau benzoxazine de l'agent de durcissement est supérieur ou égal à 0,8 et inférieur ou égal à 1,2.

4. Feuille thermoconductrice selon l'une quelconque des revendications 1 à 3, dans laquelle la teneur en charge inorganique est supérieure ou égale à 50 % en volume et inférieure ou égale à 90 % en volume par rapport au volume total du contenu solide de la composition de résine durcie.

5. Module semi-conducteur comprenant :
un dispositif semi-conducteur ;
une surface de dissipation thermique pour dissiper la chaleur générée par le dispositif semi-conducteur ; et
une feuille thermoconductrice pour transférer la chaleur à la surface de dissipation thermique, dans laquelle
la feuille thermoconductrice est la feuille thermoconductrice selon l'une quelconque des revendications 1 à 4.
